# EUROPEAN PATENT SPECIFICATION

(11) **EP 3 712 973 B1**
(45) Date of publication and mention of the grant of the patent: **28.07.2021**
(21) Application number: 20162798.1
(22) Date of filing: 12.03.2020
(51) Int. Cl.: H01L 41/22, H01L 41/09, H03H 9/17, H04R 17/00

(54) **METHOD FOR PRODUCING OSCILLATOR SUBSTRATE AND OSCILLATOR SUBSTRATE**
VERFAHREN ZUR HERSTELLUNG EINES OSZILLATORSUBSTRATS UND EIN OSZILLATORSUBSTRAT
PROCÉDÉ DE FABRICATION D'UN SUBSTRAT D'OSCILLATEUR ET SUBSTRAT D'OSCILLATEUR

(30) Priority: 19.03.2019 JP 2019051403
(43) Date of publication of application: 23.09.2020
(73) Proprietor: Ricoh Company, Ltd., Tokyo 143-8555 (JP)
(72) Inventor: ABE, Shuya, Tokyo 143-8555 (JP)
(74) Representative: Fairbairn, Angus Chisholm

(56) References cited:
- CN-B- 101 645 484
- JP-A- 2009 096 036
- US-A1- 2006 116 585
- US-B1- 6 945 115

## Description

### BACKGROUND OF THE INVENTION

### Field of the Invention

The present disclosure relates to a method for producing an oscillator substrate.

### Description of the Related Art

Hitherto, there has been known a method for producing an oscillator substrate in which an oscillating section of an oscillating membrane facing an oscillation space is configured to oscillate in a direction normal to the membrane surface of the oscillating membrane.

For example, International Publication No. WO 2015/190429 discloses a method of producing a piezoelectric device including a step of forming a lower electrode over a silicon (Si) substrate, a step of forming a piezoelectric membrane over a lower electrode, and a step of forming an upper electrode over the piezoelectric membrane. The producing method further includes a step of forming a sacrifice layer formed of, for example, a titanium (Ti) film over the substrate, and a step of forming a support layer over the sacrifice layer, wherein the lower electrode is formed over the support layer. The producing method further includes a step of forming a first opening (hole for removing a sacrifice layer) by etching in a manner that the first opening leads to the sacrifice layer from a surface of the substrate opposite to the sacrifice layer, and a step of leading an etchant to the sacrifice layer through the first opening to remove the sacrifice layer by wet etching to form a second opening (oscillation space). By this producing method, a piezoelectric device (oscillator substrate) in which a portion of the support layer facing the second opening functions as the oscillating section of an oscillating membrane and oscillates in a direction normal to the membrane surface of the oscillating membrane is produced.

An oscillator substrate in which within an oscillating membrane formed over a substrate, an oscillating section facing an oscillation space is configured to oscillate in a direction normal to a membrane surface of the oscillating membrane, is disclosed in US 6 945 115 B1. Further oscillator substrates are disclosed in US 2006/116585 A1, JP2009096036 and CN 101 645 484 B.

### SUMMARY OF THE INVENTION

There is a need that the sacrifice layer employed in the existing producing method have resistance (e.g., heat resistance) to various treatments in the process of producing the oscillator substrate and etching processability. However, it is difficult to obtain a sacrifice layer satisfying the needs.

According to one aspect of the present disclosure, a method for producing an oscillator substrate in which an oscillating section of an oscillating membrane facing an oscillation space is configured to oscillate in a direction normal to the membrane surface of the oscillating membrane includes a sacrifice layer forming step of forming a sacrifice layer within a region over a substrate intended to become the oscillation space, the sacrifice layer being formed of the same material as the substrate, an oscillating membrane forming step of forming the oscillating membrane over the sacrifice layer, a hole forming step of forming sacrifice layer removing holes in the substrate in a manner to lead to the sacrifice layer from a surface of the substrate opposite to the sacrifice layer, a protective film forming step of forming an etching protective film over an internal wall surface of the sacrifice layer removing holes, and a sacrifice layer removing step of removing the sacrifice layer by etching through the sacrifice layer removing holes to form the oscillation space.

The present disclosure can provide a sacrifice layer that satisfies needs for resistance to various treatments in the process of producing the oscillator substrate and etching processability.

### BRIEF DESCRIPTION OF THE DRAWINGS

FIG. 1 is a plan view illustrating an ultrasonic generator substrate produced by a producing method according to an embodiment;
FIG. 2 is a cross-sectional view of an ultrasonic generator substrate illustrating an A-A' cross section of FIG. 1;
FIG. 3 is a view illustrating a step of forming a sacrifice layer over a substrate in the producing method;
FIG. 4 is a view illustrating a step of forming an oscillating membrane over the sacrifice layer;
FIG. 5 is a view illustrating a step of forming a first electrode and a PZT underlying film of a piezoelectric element over the oscillating membrane;
FIG. 6 is a view illustrating a step of forming a PZT overlying film over the PZT underlying film;
FIG. 7 is a view illustrating a step of forming a second electrode over a piezoelectric film formed of the PZT underlying film and the PZT overlying film;
FIG. 8 is a view illustrating a step of forming a second insulating film, a wiring, and a protective film over the second electrode;
FIG. 9 is a view illustrating a step of forming a sacrifice layer removing hole in a back surface of the substrate;
FIG. 10 is a view illustrating a step of removing an oxide film present at the deepest portion of the sacrifice layer removing hole;
FIG. 11 is a view illustrating a step of removing a removing portion of the sacrifice layer by etching through the sacrifice layer removing hole;
FIG. 12 is a view illustrating a state of the ultrasonic generator substrate being joined and mounted on a printed circuit board;
FIG. 13 is an exemplary view illustrating a printed circuit board mounted with the ultrasonic generator substrate;
FIG. 14 is an exemplary view illustrating a state of an electrode terminal of the ultrasonic generator substrate being electrically coupled to an electrode terminal of the printed circuit board by wire bonding;
FIG. 15 is a plan view illustrating an example configuration 1 relating to positional relationship between sacrifice layer removing holes and oscillation spaces in a substrate in-plane direction in a PMUT;
FIG. 16 is a plan view illustrating a configuration example 2 relating to positional relationship between sacrifice layer removing holes and oscillation spaces in a substrate in-plane direction in a PMUT;
FIG. 17 is a plan view illustrating a configuration example 3 relating to positional relationship between sacrifice layer removing holes and oscillation spaces in a substrate in-plane direction in a PMUT;
FIG. 18 is a plan view illustrating a configuration example 3' relating to positional relationship between sacrifice layer removing holes and oscillation spaces in a substrate in-plane direction in a PMUT;
FIG. 19 is a plan view illustrating a configuration example 4 relating to positional relationship between sacrifice layer removing holes and oscillation spaces in a substrate in-plane direction in a PMUT;
FIG. 20 is a cross-sectional view corresponding to a B-B' cross section of FIG. 18;
FIG. 21 is a plan view illustrating a configuration example 5 relating to positional relationship between sacrifice layer removing holes and oscillation spaces in a substrate in-plane direction in a CMUT;
FIG. 22 is a plan view illustrating a configuration example 6 relating to positional relationship between sacrifice layer removing holes and oscillation spaces in a substrate in-plane direction in a CMUT;
FIG. 23 is a plan view illustrating a configuration example 7 relating to positional relationship between sacrifice layer removing holes and oscillation spaces in a substrate in-plane direction in a CMUT; and
FIG. 24 is a plan view illustrating a configuration example 8 relating to positional relationship between sacrifice layer removing holes and oscillation spaces in a substrate in-plane direction in a CMUT.

### DESCRIPTION OF THE EMBODIMENTS

An embodiment of applying the present disclosure to a method for producing an ultrasonic generator substrate, which is a piezoelectric element substrate as an oscillator substrate in which an oscillating section of an oscillating membrane facing an oscillation space is configured to oscillate in a direction normal to the membrane surface of the oscillating membrane, will be described below.

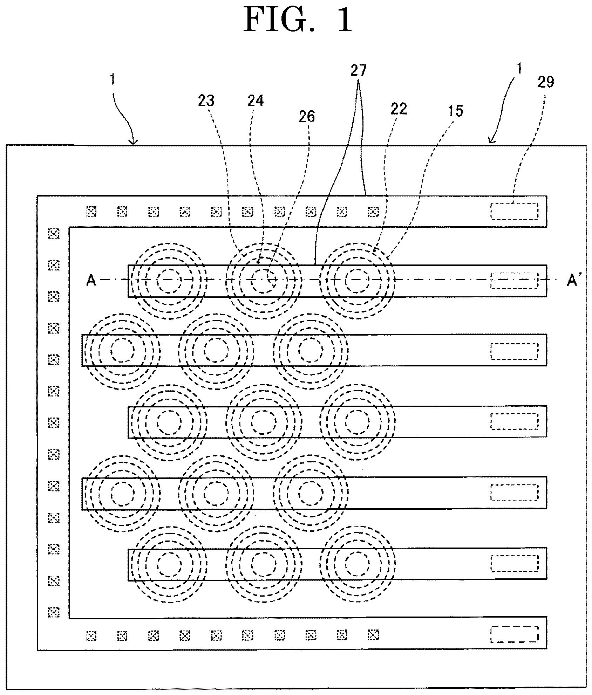

FIG. 1 is a plan view illustrating an ultrasonic generator substrate produced by the producing method according to the present embodiment.

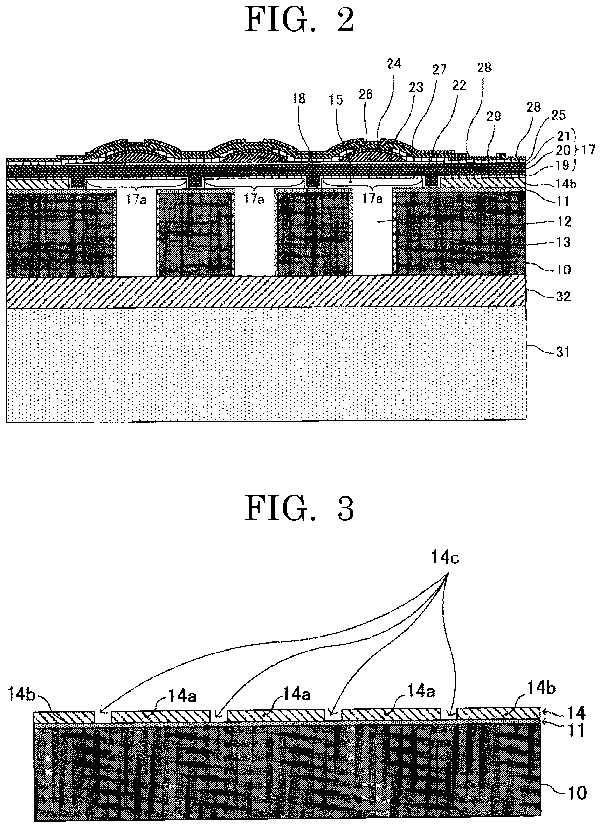

FIG. 2 is a cross-sectional view of the ultrasonic generator substrate illustrating the A-A' cross section of FIG. 1.

The ultrasonic generator substrate 1 according to the present embodiment includes, for example, a substrate 10, oscillation spaces 15, a laminate film (a silicon oxide film 19, a polysilicon film 20, and a first insulating film 21) functioning as an oscillating membrane 17, a first electrode 22, a piezoelectric film 23, a second electrode 24, a second insulating film 25, openings 26 in the second insulating film, a wiring 27, a protective film 28, and an electrode terminal 29.

The ultrasonic generator substrate 1 of the present embodiment is configured to generate ultrasonic waves in a manner that when a drive voltage is applied across the first electrode 22 and the second electrode 24, the piezoelectric film 23 extends and contracts in a direction parallel with the substrate in-plane direction, and oscillating sections 17a of the oscillating membrane 17 formed integrally with the piezoelectric film oscillate in a direction normal to the membrane surface of the oscillating membrane 17. The drive voltage is supplied from outside via the electrode terminal 29 through the wiring 27. In the present embodiment, there are a plurality (five in the example of FIG. 1) of oscillator groups each formed of a plurality (three in the example of FIG. 1) of individual oscillators (piezoelectric elements) to be driven simultaneously. The second electrode 24 is an individual electrode provided per oscillator group. The first electrode 22 is a common electrode shared by all oscillators. The number of oscillators actually formed over the ultrasonic generator substrate 1 is typically by far greater than the number of oscillators illustrated.

The ultrasonic generator substrate 1 is joined and mounted via a joining member 32 on a printed circuit board 31 mounted with an integrated circuit (IC) and other parts as illustrated in FIG. 2. As the joining member 32, for example, a dry film joining member called a die attach film can be used.

A material having an excellent heat resistance, a sufficient stiffness, and a sufficient strength and easily etchable is preferable as the substrate 10. In the present embodiment, a single crystal silicon (Si) substrate is used.

The oscillation spaces 15 facing the oscillating sections 17a of the oscillating membrane 17 are formed in the front surface (i.e., the upper surface in FIG. 2) of the substrate 10, as spaces secured for the oscillating sections 17a and the oscillators formed of piezoelectric elements to oscillate. In the present embodiment, one oscillation space 15 is formed per oscillator. Each oscillation space 15 is partitioned by a partitioner 18 formed of a silicon oxide film 19 and a polysilicon film 20.

In a below-described process for producing the ultrasonic generator substrate 1 of the present embodiment, a sacrifice layer 14 to be removed for forming the oscillation spaces 15 is formed over the substrate 10. Remaining layers 14b, which are the rest of the sacrifice layer 14 formed, except the portions to become the oscillation spaces 15 and the portions in which the partitioners 18 are to be formed, are kept without being removed. The remaining layers 14b kept in this way can ensure flatness of the upper surface of the oscillating membrane 17 to be formed over the sacrifice layer.

The sacrifice layer 14 of the present embodiment is formed of silicon (Si), which is the same material as the substrate 10. With the sacrifice layer 14 formed of the same material as the substrate 10, the substrate10 and the sacrifice layer 14 formed over the substrate 10 have the same physical properties such as coefficient of thermal expansion and coefficient of thermal shrinkage in common, and can overcome troubles such as distortion and peel that may occur in various treatments in the production process when both are formed of different materials.

In the present embodiment, it may be possible to further laminate a film for controlling the stress in the oscillating sections 17a of the oscillating membrane 17. Specifically, it may be possible to laminate a silicon nitride film that is generally regarded to have a high tensile stress.

As an example of the oscillating membrane 17 of the present embodiment, the silicon oxide film 19 is formed by a LP-CVD (Low Pressure-Chemical Vapor Deposition) method to have a thickness of about 0.5 micrometers. The polysilicon film 20 is formed by the LP-CVD method to have a thickness of about 3 micrometers. The first insulating film 21 is formed by the LP-CVD method to have a thickness of about 0.5 micrometers.

As an example of the piezoelectric element as an electromechanical transducer formed over the first insulating film 21, the first electrode 22 is formed using platinum (Pt) over the first insulating film 21 via a close adhesive layer TiO₂. The piezoelectric film 23 is formed as a film of lead zirconate titanate (PZT). The second electrode 24 formed of platinum (Pt) like the first electrode is formed over the piezoelectric film 23.

The second insulating film 25 formed over the second electrode 24 serves to secure insulation between the wiring 27 and the first electrode 22 and to prevent moisture absorption of the piezoelectric element and damages in the subsequent production process. The second insulating film 25 may be, for example, a silicon oxide film having a thickness of about 0.6 micrometers. The opening 26 is opened in the second insulating film 25 at the position facing the second electrode 24 of each piezoelectric element. The wiring 27 is formed over the second insulating film 25, and the wiring 27 is coupled to the second electrode 24 through the opening 26 in the second insulating film 25.

One end of the wiring 27 serves as the electrode terminal 29, which is an electric contact with the outside. The wiring 27 may be, for example, copper-added aluminum having a thickness of about 1 micrometer and laminated over a titanium film having a thickness of about 50 nm. The protective film 28 is formed over the wiring 27 to protect the wiring 27 from, for example, corrosion. The protective film 28 may be, for example, a silicon nitride film having a thickness of about 0.8 micrometers. The protective film 28 has an opening at a position facing the electrode terminal 29, to enable electric contact between the electrode terminal 29 and the outside.

Next, the method for producing the ultrasonic generator substrate 1 of the present embodiment will be described with reference to FIG. 3 to FIG. 14.

First, as illustrated in FIG. 3, an oxide film 11 and the sacrifice layer 14 are formed over the substrate 10 formed of silicon (Si), and separation trenches 14c are formed to separate the sacrifice layer 14. The pattern shape of the separation trenches 14c is defined in a manner to border the perimeter of removing portions 14a of the sacrifice layer 14 to be subsequently removed for the oscillation spaces 15. The separation trenches 14c are formed by, for example, photolithography/etching to have a trench width of, for example, about 2 micrometers. In the present embodiment, the sacrifice layer 14 is also formed within regions other than the removing portions 14a and the separation trenches 14c, such that the regions are kept as the remaining layers 14b. The sacrifice layer 14 is formed to have a thickness of, for example, about 1 micrometer.

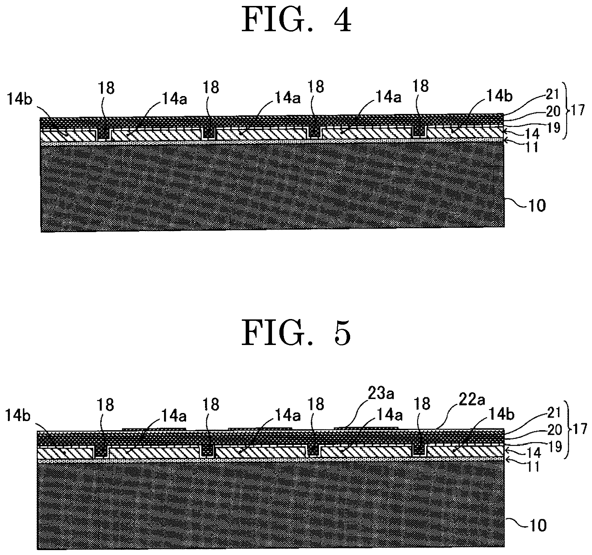

Next, as illustrated in FIG. 4, the first insulating film 21 formed of the silicon oxide film 19, the polysilicon film 20, and the silicon oxide film is formed by the LP-CVD method. For polysilicon, it is common to employ a film formation method using a SiH4 gas and a temperature environment of about 630 degrees C. However, in this example, the polysilicon film 20 is formed by a film formation method using a Si₂H₆ gas and a temperature environment of about 520 degrees C in order to suppress surface roughness. In this case, a silicon (Si) film formed is in an amorphous state. However, the amorphous silicon is crystallized in the subsequent step of forming the silicon oxide film 19, to become a polysilicon. The film formation method using a SiH₄ gas and a temperature environment of about 630 degrees C results in a high surface roughness. However, it may be possible to form the polysilicon film 20 to have a thickness greater than the final intended thickness and reduce the surface roughness by touch polishing (polishing with a low amount of polishing).

The silicon oxide film 19, the polysilicon film 20, and the first insulating film 21 have a thickness of, for example, 0.5 micrometers, 3 micrometers, and 0.5 micrometers, respectively. The thickness of each film is appropriately set depending on the size of the oscillator and the frequency to be employed.

With a trench width of about 2 micrometers, the separation trenches 14c can be almost filled with the polysilicon film 20. Strictly, however, slight dents corresponding to the separation trenches 14c occur in the upper surface of the polysilicon film 20. However, the dents are extremely small compared with the depth of the separation trenches 14c (i.e., the thickness of the sacrifice layer 14). As described above, for example, a silicon nitride film may be additionally laminated for stress adjustment.

Subsequently, a titanium dioxide (TiO₂) film having a thickness of about 85 nm is formed as a close adhesive layer over the first insulating film 21. As the film formation method, it is possible to employ a method of forming a titanium (Ti) film by sputtering to have a thickness of about 60 nm and subsequently oxidizing the titanium film by RTA (Rapid Thermal Annealing) in an oxygen flowing atmosphere.

Next, as illustrated in FIG. 5, a platinum (Pt) layer 22a to become the first electrode 22 is formed by sputtering to have a thickness of 200 nm over the first insulating film 21 over which the close adhesive layer is formed. A lead zirconate titanate (PZT) underlying film 23a to constitute the piezoelectric film 23 is formed to have a thickness of about 80 nm over the platinum layer 22a, and patterned by, for example, photolithography/etching in a manner that the portions to become the oscillators remain. For example, the PZT underlying film 23a is formed by a method of applying a precursor liquid containing, specifically, lead acetate, a zirconium alkoxide compound, and a titanium alkoxide compound as the starting materials by spin coating, and subsequently drying, pyrolyzing, and crystallizing the materials.

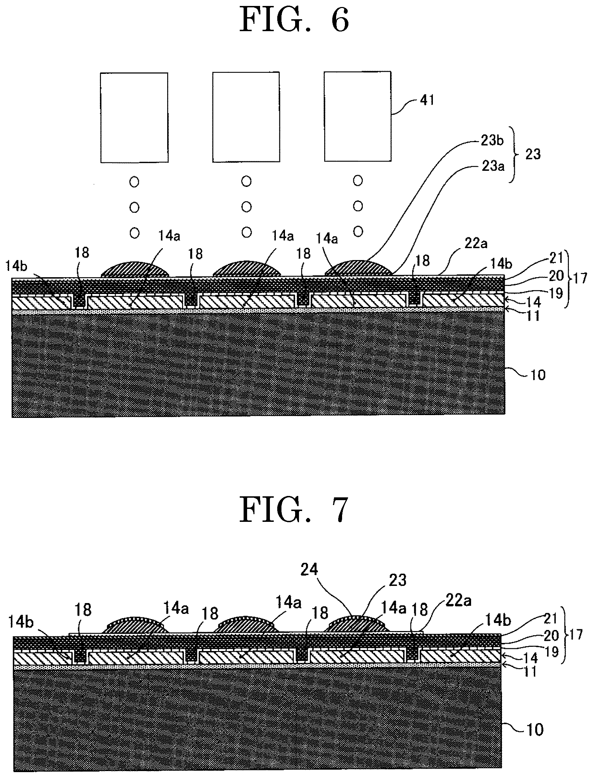

Next, as illustrated in FIG. 6, the PZT overlying film 23b is formed over the PZT underlying film 23a. Specifically, a CSD liquid coating machine mounted with a CSD liquid discharging head 41 serving as a liquid discharging head is used to discharge and apply a CSD liquid, which is the precursor of the PZT overlying film 23b, over the PZT underlying film 23a. According to the CSD liquid coating machine, the CSD liquid discharging head 41 moves above the substrate 10 or the substrate 10 is moved below the CSD liquid discharging head 41, such that the CSD liquid is discharged selectively to the positions at which the PZT underlying films 23a are formed.

It is preferable to treat the external circumferential surfaces of the regions over which the PZT overlying films 23b are to be formed, to have liquid repellency to the CSD liquid. This liquid repellency imparting treatment makes it possible to prevent the CDS liquid from overflowing and spreading from the regions over which the PZT overlying films 23b are intended to be formed (i.e., the positions corresponding to the PZT underlying films 23a) even if the CSD liquid lands on slightly wrong positions, and to appropriately apply the CSD liquid only to the positions of the PZT underlying films 23a.

Next, the CSD liquid applied in this way is dried, pyrolyzed, and crystallized, to form the PZT overlying films 23b. The amount of the CSD liquid to be applied is adjusted in a manner that the thickness of the PZT overlying films 23b after crystallized is, for example, about 100 nm. The greater the film thickness formed by one step, the better the productivity, but the more likely the formed films is cracked. Therefore, the film thickness formed by one step is preferably about 100 nm as described above.

The liquid repellency treatment described above, discharging the CSD liquid (selective application), and the step of drying, pyrolyzing, and crystallizing are repeatedly performed until the PZT overlying films 23b having the desired thickness are obtained. In the present embodiment, the steps are repeated about twenty times, to form the piezoelectric film 23 having a thickness of 2 micrometers.

Next, a platinum film to become the second electrode 24 is formed by sputtering. The thickness of the platinum film is, for example, 100 nm. Subsequently, the platinum film is treated by photolithography/etching, to be patterned such that only the portions corresponding to the second electrodes 24 remain as illustrated in FIG. 7. Successively, the platinum layer 22a is patterned by photolithography/etching as illustrated in FIG. 7, to form the first electrode 22.

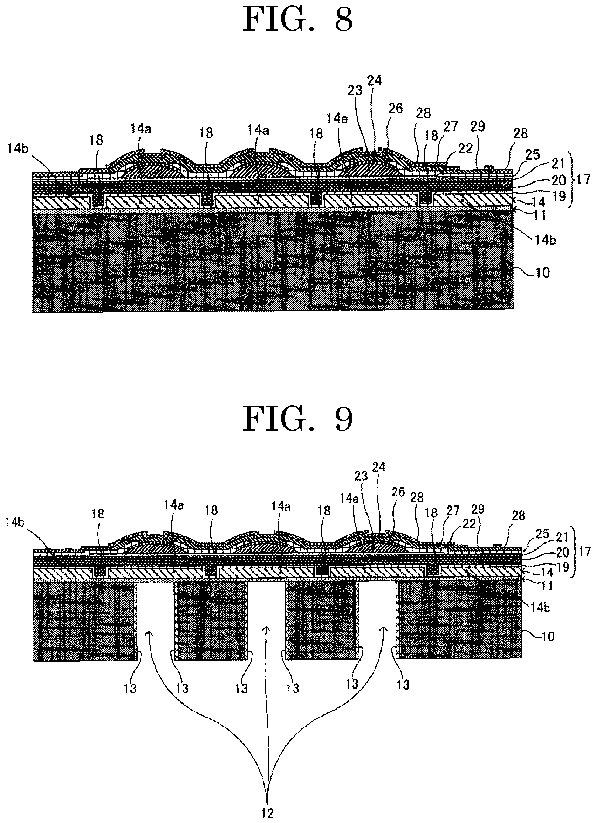

Next, the second insulating film 25 is formed as illustrated in FIG. 8. In the present embodiment, the second insulating film 25 is formed by a plasma CVD method to have a thickness of about 0.6 micrometers, using monosilane (SiH4) and a nitrous oxide (N₂O) gas as raw materials. Subsequently, the openings 26 are formed in the second insulating film 25 by photolithography/etching as illustrated in FIG. 8. Then, a film of the aforementioned wiring material, i.e., Al-Cu (with a thickness of 1 micrometer)/Ti (with a thickness of 50 nm) is formed by sputtering over the resultant, and patterned by photolithography/etching, to form the wiring 27 as illustrated in FIG. 8. Further, as illustrated in FIG. 8, the protective film 28 is formed over the resultant and bored at the position corresponding to the electrode terminal 29. In the present embodiment, as the protective film 28, a silicon nitride film having a thickness of about 1 micrometer is formed by a plasma CVD method using monosilane (SiH4), nitrous oxide, and an ammonia (NH₃) gas as raw materials. The openings can be formed by photolithography/etching.

Next, as illustrated in FIG. 9, sacrifice layer removing holes 12 leading to the sacrifice layer are formed in the surface of the substrate 10 opposite to the sacrifice layer 14 (hereinafter, the opposite surface will be referred to as "back surface"). Specifically, in order to reduce the process time and improve the processing dimensional accuracy, the back surface of the substrate 10 is processed by backgrinding and polishing, to reduce the thickness of the substrate 10 to 200 micrometers. Subsequently, a support substrate is bonded to the element formed surface (the surface at the upper side of FIG. 9) of the substrate 10 over which the piezoelectric element is formed. A silicon wafer coated with a thermal oxide film can be used as the support substrate. A thermal release tape can be used for bonding.

Subsequently, a resist mask is formed by photolithography over the back surface of the substrate at other than the sacrifice layer removing holes 12, and the sacrifice layer removing holes 12 are formed in the back surface of the substrate 10 by dry etching as illustrated in FIG. 9.

Dry etching can be suitably performed according to a so-called Bosch process (a process of alternately repeating etching by SF₆ plasma and formation of a side wall protective film by C₄F₈ plasma) using a silicon deep reactive etcher. That is, formation of the sacrifice layer removing holes 12 by the Bosch process makes it possible for the side wall protective film formed by C₄F₈ plasma to protect the internal wall surface of a portion closer to the entrance of the sacrifice layer removing holes 12 and etched earlier from being etched when a deeper portion is etched. This makes it possible to form a hole having the intended dimension from the entrance to the deepest portion of the sacrifice layer removing holes 12.

In the present embodiment, as described above, the sacrifice layer 14 is formed of silicon (Si), which is the same material as the substrate 10. Therefore, when removing the removing portions 14a of the sacrifice layer 14 through the sacrifice layer removing holes 12 in the substrate 10 by etching in the sacrifice layer removing step described below, the internal wall surface of the sacrifice layer removing holes 12 is at the risk of being etched. Hence, in the present embodiment, in order to prevent the sacrifice layer removing holes 12 in the substrate 10 from being etched when etching the removing portions 14a of the sacrifice layer 14, an etching protective film 13 is formed over the internal wall surface of the sacrifice layer removing holes 12 as illustrated in FIG. 9. This suppresses the internal wall surface of the sacrifice layer removing holes 12 from being etched when etching the removing portions 14a of the sacrifice layer 14 in the sacrifice layer removing step described below.

The etching protective film 13 may be formed after the sacrifice layer removing holes 12 are formed. However, it is preferable to form the etching protective film 13 while forming the sacrifice layer removing holes 2 by dry etching, because this can simplify the production process. Specifically, for example, as described above, when forming the sacrifice layer removing holes 12, the side wall protective film is formed by C₄F₈ plasma using the silicon deep reactive etcher. The side wall protective film is formed to have a greater thickness than the thickness of the side wall protective film formed when simply forming the sacrifice layer removing holes 12, such that the side wall protective film having a sufficient thickness will remain as the etching protective film 13 over the internal wall surface of the sacrifice layer removing holes 12 after the sacrifice layer removing holes 12 have been formed. That is, the side wall protective film having a thickness enough to protect the sacrifice layer removing holes 12 in the substrate 10 from being etched when etching the removing portions 14a of the sacrifice layer 14 is kept remaining and used as the etching protective film 13.

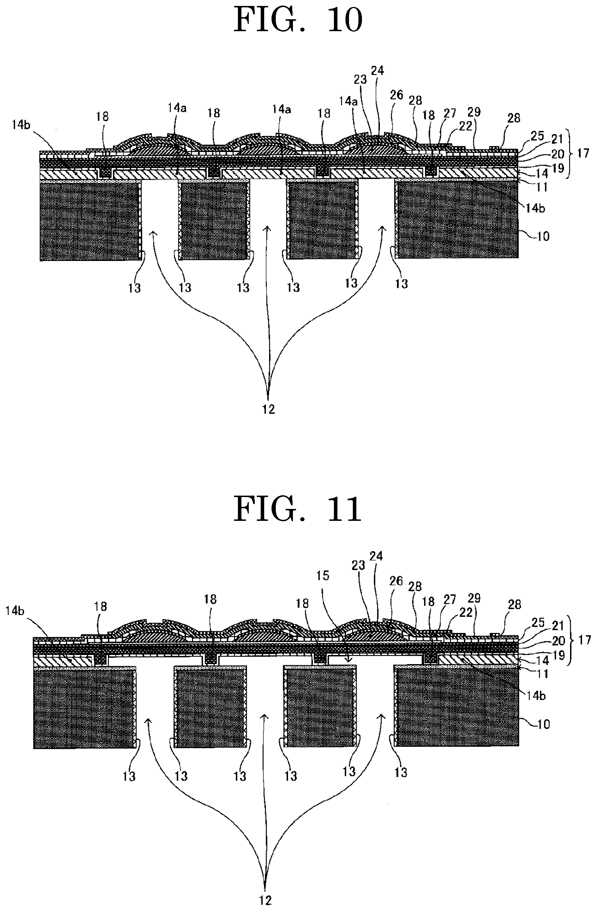

After the etching protective film 13 is formed over the internal wall surface of the sacrifice layer removing holes 12 in the way described above, the same silicon deep reactive etcher is successively used but with switching of the gas system to, for example, CHF₃ + O₂, to dry-etch the oxide film 11. Here, with a bias voltage for attracting ions set relatively high, the oxide film 11 present at the deepest portion of the sacrifice layer removing holes 12 is removed, to expose the removing portions 14a of the sacrifice layer 14 as illustrated in FIG. 10.

The same silicon deep reactive etcher is further successively used to remove the removing portions 14a of the sacrifice layer 14 by dry etching. More specifically, SF₆ plasma is delivered to the removing portions 14a of the sacrifice layer 14 through the sacrifice layer removing holes 12, and the attracting bias is set to zero, to perform dry etching. As a result, as illustrated in FIG. 11, the removing portions 14a of the sacrifice layer 14 are removed, and the spaces from which the removing portions 14a have been removed become the oscillation spaces 15 facing the oscillating sections 17a of the oscillating membrane 17.

In the present embodiment, as illustrated in FIG. 11, the removing portions 14a of the sacrifice layer 14 have portions extending outward in the left and right directions of FIG. 11 from the internal wall surface of the sacrifice layer removing holes 12. Here, the dry etching described above advances isotopically, and hence advances also in the horizontal direction. Therefore, the extending portions of the sacrifice layer 14 are also appropriately removed.

The extending portions of the oscillation spaces 15 are faced with some parts of the element formed surface of the substrate 10. Therefore, when removing the removing portions 14a of the sacrifice layer 14 by dry etching, there is a risk that these parts may be etched. However, in the present embodiment, the parts are coated with the oxide film 11 serving as a second etching protective film configured to protect the parts from etching. Therefore, the parts are less susceptible to etching.

Subsequently, the support substrate bonded to the element formed surface of the substrate 10 is removed, and the substrate 10 is diced into chips, to complete the ultrasonic generator substrate 1 (ultrasonic generator chip).

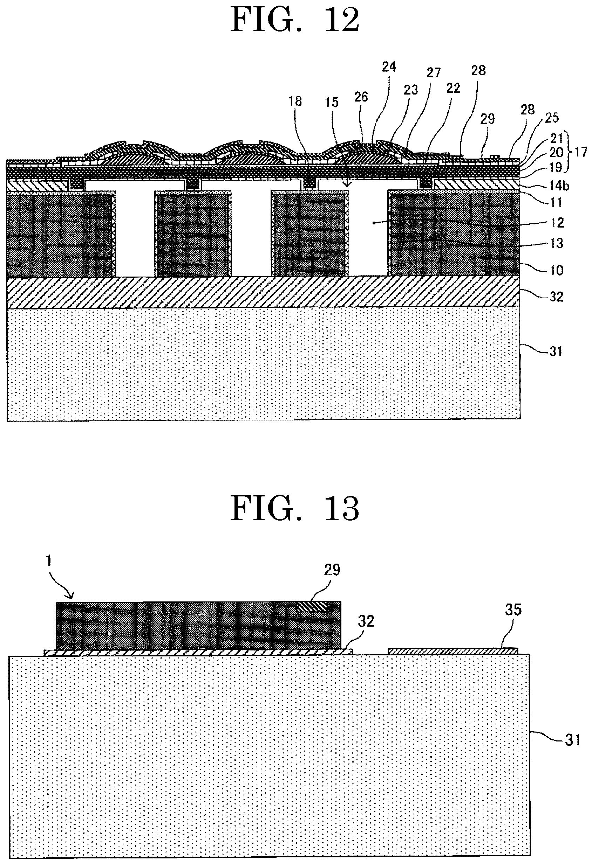

The ultrasonic generator substrate 1 obtained in this way is joined to and mounted on the printed circuit board 31 via the joining member 32 as is illustrated in FIG. 12. As the joining member 32, for example, a dry film joining member called a die attach film can be suitably used. Use of a dry film joining member makes it possible to avoid troubles such as disturbance of oscillation due to a flow of an adhesive into the oscillation spaces 15 through the sacrifice layer removing holes 12.

FIG. 13 is an exemplary view illustrating the printed circuit board 31 mounted with the ultrasonic generator substrate 1.

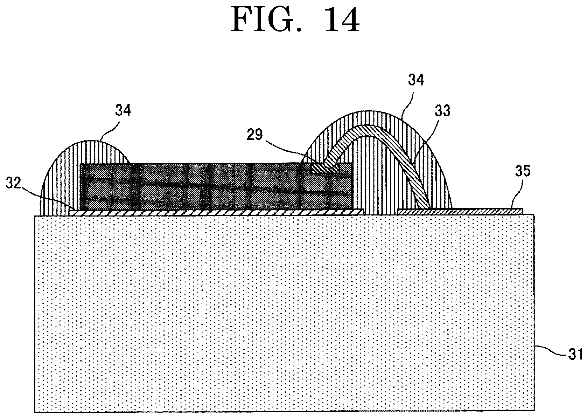

FIG. 14 is an exemplary view illustrating a state of the electrode terminal 29 of the ultrasonic generator substrate 1 being electrically coupled to an electrode terminal 35 of the printed circuit board 31 by wire bonding.

The ultrasonic generator substrate 1 is mounted on the printed circuit board 31, and then the electrode terminal 29 of the ultrasonic generator substrate 1 is electrically coupled to the electrode terminal 35 of the printed circuit board 31 through a wire 33 by wire bonding. Subsequently, the whole of the wire 33, the electrode terminal 29 of the ultrasonic generator substrate 1, and the electrode terminal 35 of the printed circuit board 31 are sealed with a sealing resin 34. This more reliably ensures sealing of the oscillation spaces 15 leading to the sacrifice layer removing holes 12.

According to the producing method of the present embodiment, even when the substrate 10 and the sacrifice layer 14 are formed of the same material (silicon (Si)), it is possible to form the oscillation spaces 15 having a desired shape and desired dimensions accurately. The formation accuracy of the oscillation spaces 15 has a direct bearing on the shape and the dimensional accuracy of the oscillating sections 17a of the oscillating membrane 17. The shape and the dimensional accuracy of the oscillating sections 17a of the oscillating membrane 17 are significantly influential to the oscillation characteristics (e.g., oscillation frequency and amount of displacement) of the oscillating sections 17a. Therefore, if the accuracy is poor, desired oscillation characteristics cannot be obtained. According to the present embodiment, even when the substrate 10 and the sacrifice layer 14 are formed of the same material (silicon (Si)), it is at least possible to form the oscillation spaces 15 with the same level of accuracy as hitherto obtained.

Furthermore, because the same material is used in the substrate 10 and the sacrifice layer 14, it is easy for also the sacrifice layer 14, like the substrate 10, to satisfy resistance (e.g., heat resistance) to various treatments (e.g., a heating treatment) in the production process and etching processability. In addition, the same etcher (etching device) as used for processing (e.g., etching) the substrate 10 can be used to process (e.g., etch) the sacrifice layer 14, leading to an improved productivity. Particularly, in the present embodiment, the series of steps from the step of forming the sacrifice layer removing holes 12 to the step of removing the sacrifice layer 14 can be successively performed in the same device, leading to a significant improvement of the productivity.

Further, in the present embodiment, use of silicon (Si) as the material of the sacrifice layer 14 like the substrate 10 results in a high etching processability, making it possible to realize formation of the oscillation spaces 15 with a better accuracy than hitherto obtained. In addition, silicon (Si) can be etched by dry etching not by wet etching using, for example, an electrolyte. Because dry etching can be employed, the problems of wet etching (e.g., the problem of how to reliably perform drying after wet etching and the problem of adhesion to the structure) can be overcome.

The ultrasonic generator substrate 1 of the present embodiment employs a so-called PMUT (Piezo Micromachined Ultrasonic Transducer). However, the present embodiment can likewise be applied to a product employing a CMUT (Capacitive Micromachined Ultrasonic Transducer).

A PMUT and a CMUT have differences in the functions of the oscillation spaces 15 and accompanying differences in the configuration. These differences will be described below.

Typically, the structural components of a PMUT configured to perform the main function of an electromechanical transducer are disposed intensively at the oscillating membrane 17 side of the oscillation spaces 15. The oscillation spaces 15 are spaces configured for the oscillating sections 17a of the oscillating membrane 17 to be displaced (oscillated). Here, the main function means a function of causing the oscillating sections 17a of the oscillating membrane 17 to oscillate. The structural components for the function are the oscillating membrane 17, and the first electrode 22, the piezoelectric membrane 23, and the second electrode 24 that constitute a piezoelectric element.

Because a PMUT has a structure to secure the oscillating membrane 17 on the external circumference of the oscillation spaces 15, the dimensions and shape of the oscillation spaces 15 in the substrate in-plane direction coincide with the dimensions and shape of the oscillating sections 17a of the oscillating membrane 17. Hence, there is a need for making the dimensions and shape of the oscillation spaces 15 in the substrate in-plane direction highly accurate. However, the oscillation spaces 15 need not have a high dimensional accuracy in the depth direction (i.e., a direction orthogonal to the substrate surface) so long as the oscillation spaces 15 have a sufficient depth that does not disturb displacement (oscillation) of the oscillating membrane 17. The arrangement of the sacrifice layer removing holes 12 leading to the oscillation spaces 15 does not stand as a particular problem even when the sacrifice layer removing holes 12 are disposed immediately below the oscillators.

As compared, a CMUT has two electrodes disposed in a manner to face each other via an oscillation space, and is configured to oscillate the oscillating section of the oscillating membrane by means of changes of an electrostatic force acting across the two electrodes. Hence, what matter to the oscillation space are not only the dimensions and shape in the substrate in-plane direction, but also the dimensional accuracy in the depth direction. Moreover, there is a need for disposing two electrodes in a manner to face each other via the oscillation space in the depth direction of the oscillation space. Therefore, when forming a sacrifice layer removing hole 12 needed for removing the sacrifice layer for forming the oscillation space, there is a need for avoiding positioning the sacrifice layer removing hole 12 immediately below the oscillator.

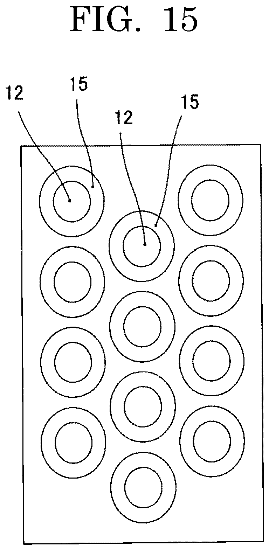

Based on the differences described above, FIG. 15 to FIG. 19 illustrate examples of positional relationship between the sacrifice layer removing holes 12 and the oscillation spaces 15 of the PMUT.

FIG. 15 to FIG. 19 are plan views illustrating example configurations with different positional relationships between the sacrifice layer removing holes 12 and the oscillation spaces 15 in the substrate in-plane direction of the PMUT.

The configuration example 1 of FIG. 15 is an example in which each oscillator has a circular shape, an oscillation space 15 is formed per oscillator, and a sacrifice layer removing hole 12 is formed per oscillator. The shape of the oscillator (the shape in the plane orthogonal to the oscillating direction (i.e., the direction normal to the sheet of the drawing) is a circular shape in FIG. 15, but may also be a shape having an aspect ratio of almost 1 such as a square and a regular hexagon. In the configuration example 1, it is preferable to dispose the sacrifice layer removing hole 12 about the center of the oscillation space 15 because a large processing tolerance can be secured.

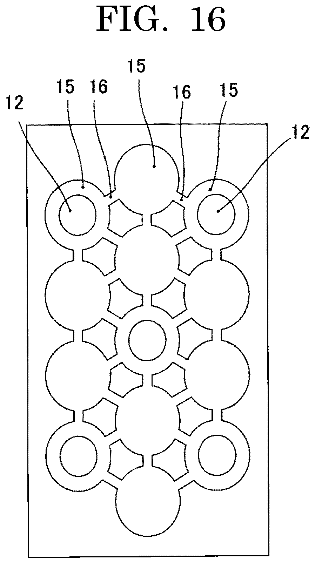

The configuration example 2 of FIG. 16 is an example in which the oscillators are disposed over the substrate in the same manner as in the example of FIG. 15, but the oscillation spaces 15 of adjoining oscillators are linked to each other through a linking path 16. No sacrifice layer removing hole 12 is disposed at some oscillators. The oscillation space 15 of an oscillator at which no sacrifice layer removing hole 12 is disposed is formed by removing the removing portion 14a of the sacrifice layer 14 by etching through the linking path 16.

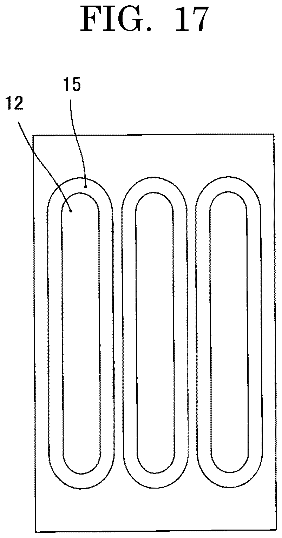

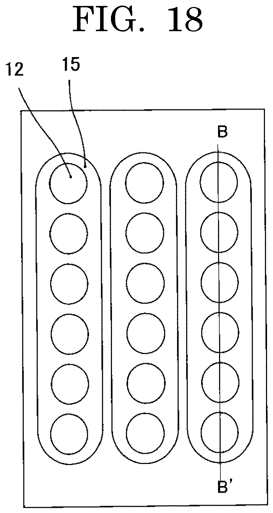

The configuration example 3 of FIG. 17 is an example in which the shape of the oscillator is not a circular shape but an elongate shape such as an ellipse in consideration of, for example, the characteristics of the oscillator. A chamfered elongate shape is preferable in order to avoid concentration of stress in the oscillating membrane. In this case, the shape of the oscillation spaces 15 is an elongate shape. In the configuration example 3 of FIG. 17, the shape of the sacrifice layer removing holes 12 is also an elongate shape that is a size smaller than the oscillation spaces 15. Meanwhile, as illustrated in the configuration example 3' of FIG. 18, it is also possible that the shape of the sacrifice layer removing holes 12 is a circular shape, and a plurality of sacrifice layer removing holes 12 are formed along the elongate direction of the oscillation spaces 15.

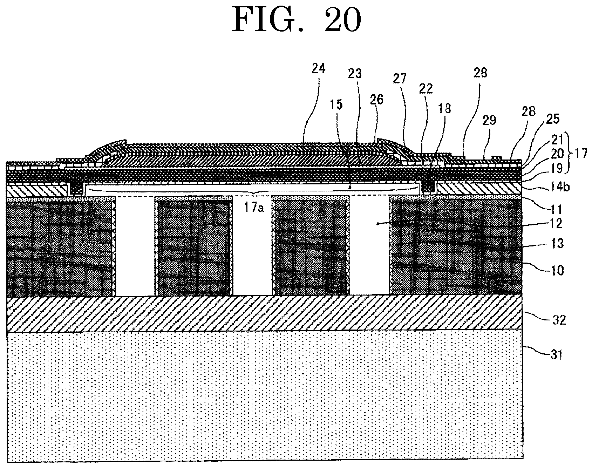

FIG. 20 is a cross-sectional view corresponding to the B-B' cross section of FIG. 18. In FIG. 20, for expediency of illustration, the number of sacrifice layer removing holes 12 is different from the number in FIG. 18.

In the configuration example 3' of FIG. 18, the partitioning walls between the sacrifice layer removing holes 12 function as beams and impart a greater stiffness to the ultrasonic generator substrate 1 than when the sacrifice layer removing holes 12 have an elongate shape as in the configuration example 3 of FIG. 17. Generally, a configuration including beams has a much greater stiffness than a configuration including no beams even if the width of the beams is not so large (for example, about 20 micrometers). A greater stiffness enables a better suppression of interference between the oscillators. The process time needed to remove the sacrifice layer 14 is not become so long if the sacrifice layer removing holes 12 are disposed densely. In this respect, the configuration example 3' is preferred to the configuration example 3.

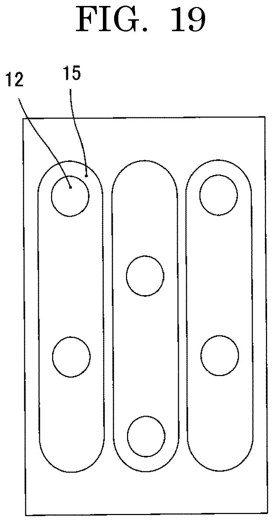

The configuration example 4 of FIG. 19 is an example in which the shape of the oscillators is an elongate shape as in the configuration example 3' of FIG. 18, but the number of sacrifice layer removing holes 12 disposed per oscillation space 15 is less. The configuration example 4 needs a longer process time to remove the sacrifice layer 14 than needed in the configuration example 3' of FIG. 18, but can obtain a greater substrate stiffness.

In any of the configuration examples 1 to 4 described above, the sacrifice layer removing holes 12 are disposed below the oscillators (disposed in a flat overlapping manner). As described above, a PMUT can employ such a configuration.

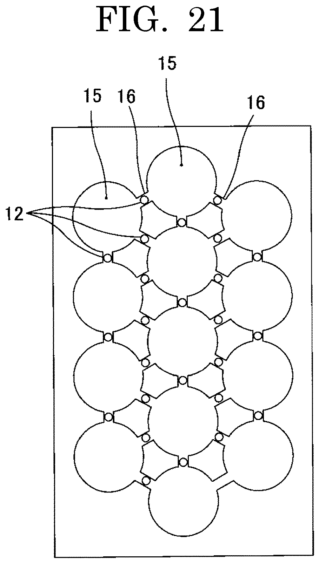

FIG. 21 to FIG. 24 illustrate example positional relationships between the sacrifice layer removing holes 12 and the oscillation spaces 15 of a CMUT.

FIG. 21 to FIG. 24 are plan views illustrating configuration examples with different positional relationships between the sacrifice layer removing holes 12 and the oscillation spaces 15 in the substrate in-plane direction of the CMUT.

The configuration example 5 of FIG. 21 is an example in which each oscillator has a circular shape, the oscillation space 15 is formed per oscillator, and the oscillation spaces 15 of adjoining oscillators are linked to each other through a linking path 16. The shape of the oscillator (the shape in the plane orthogonal to the oscillating direction (i.e., the direction normal to the sheet of the drawing) is a circular shape in FIG. 21, but may also be a shape having an aspect ratio of almost 1 such as a square and a regular hexagon.

By the operation principle, a CMUT needs to have a driving electrode at a position that faces the oscillating section 17a of the oscillating membrane 17 via the oscillation space 15. Therefore, it is common to dispose the sacrifice layer removing hole 12 at a position that does not overlap the oscillating section 17a. The configuration example 5 is an example in which the sacrifice layer removing hole 12 is disposed in the linking path 16. In this case, there is a need for forming the sacrifice layer removing hole 12 to have a smaller diameter than in the configuration examples 1 and 2 illustrated in FIG. 15 and FIG. 16. Further, because the sacrifice layer removing hole 12 has a greater aspect ratio, the process time needed to form the sacrifice layer removing hole 12 is longer.

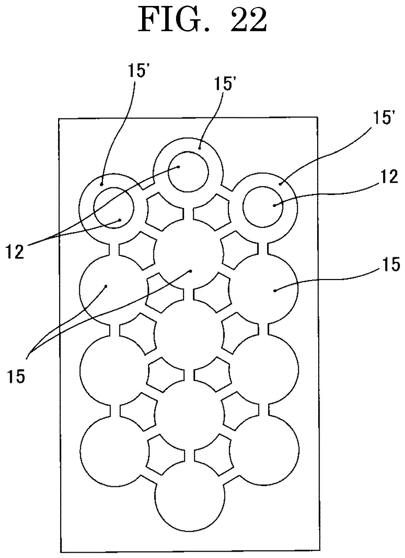

In the configuration example 6 of FIG. 22, the oscillators are disposed over the substrate and adjoining oscillation spaces 15 are linked to each other through a linking path 16 in the same manner as in the example of FIG. 21, but the sacrifice layer removing holes 12 are formed at the positions facing the oscillation spaces 15' at which no oscillator is disposed. The configuration example 6 is advantageous over the configuration example 5 of FIG. 21 in that the sacrifice layer removing holes 12 are easier to form because the sacrifice layer removing holes 12 can be formed to have a large diameter.

However, in the configuration example 6, the oscillation space 15 at which an oscillator is disposed is formed by removing the removing portion 14a of the sacrifice layer 14 by etching through a sacrifice layer removing hole 12, the linking path 16, and other oscillation spaces 15. Hence, an oscillation space 15 that is far from a sacrifice layer removing hole 12 needs a long process time. Moreover, there is a possibility that an etching-stop layer during etching for removing the removing portions 14a of the sacrifice layer 14 may have a film thickness distribution from oscillation spaces 15 closer to the sacrifice layer removing hole 12 to oscillation spaces 15 farther from the sacrifice layer removing hole 12. This is because even an etching-stop layer cannot rarely remain unetched at all, but etched gradually during a long time of etching, although depending on the materials and etchants. Therefore, in the configuration example 3, it is desirable to set the arrangement of the sacrifice layer removing holes 12 taking into consideration the influence of this factor on the oscillator characteristics and processability.

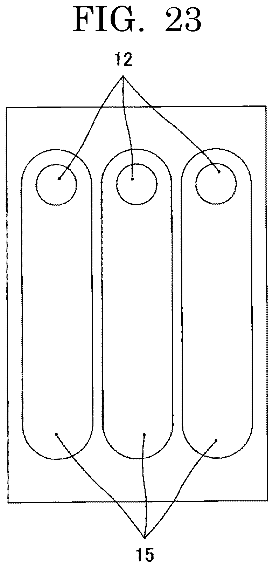

The configuration example 7 of FIG. 23 is an example in which the shape of the oscillator is not a circular shape but an elongate shape such as an ellipse in consideration of, for example, the characteristics of the oscillator. A chamfered elongate shape is preferable in order to avoid concentration of stress in the oscillating membrane. In the configuration example 7, the sacrifice layer removing hole 12 is disposed closely to an end of the oscillator (closely to an end in the elongate direction), and the removing portion 14a of the sacrifice layer 14 is removed by etching through this sacrifice layer removing hole 12 to form the oscillation space 15.

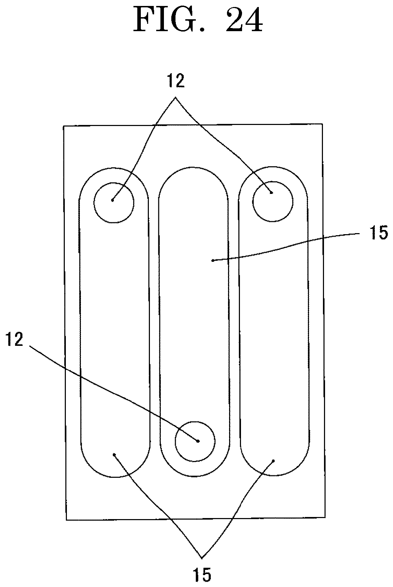

The configuration example 8 of FIG. 24 is an example in which the shape of an oscillator is an elongate shape as in the configuration example 7 of FIG. 23, but the sacrifice layer removing holes 12 are disposed at ends of opposite sides between adjoining oscillators. A greater interval between the sacrifice layer removing holes 12 can improve the stiffness of the substrate.

The embodiment described above is an example, and each embodiment described below has own characteristic effects.

### [First embodiment]

The first embodiment is a method for producing an oscillator substrate (e.g., an ultrasonic generator substrate 1) in which an oscillating section 17a of an oscillating membrane 17 facing an oscillation space 15 is configured to oscillate in a direction normal to the membrane surface of the oscillating membrane, and includes a sacrifice layer forming step of forming a sacrifice layer 14 within a region over a substrate 10 intended to become the oscillation space using the same material as the substrate, an oscillating membrane forming step of forming the oscillating membrane over the sacrifice layer, a hole forming step of forming a sacrifice layer removing hole 12 in the substrate in a manner to lead to the sacrifice layer from a surface of the substrate opposite to the sacrifice layer, a protective film forming step of forming an etching protective film 13 over an internal wall surface of the sacrifice layer removing hole, and a sacrifice layer removing step of removing the sacrifice layer by etching through the sacrifice layer removing hole to form the oscillation space.

Existing producing methods use different materials for the sacrifice layer and the substrate in order to prevent the substrate from being etched when removing the sacrifice layer by etching through the sacrifice layer removing hole formed in the substrate. However, because treatments needed such as a heating treatment are applied to the sacrifice layer during production of the oscillator substrate, the sacrifice layer needs to have resistance (e.g., heat resistance) to various treatments in the production process. In addition, the sacrifice layer needs to have etching processability because there is a need for removing the sacrifice layer by etching through the sacrifice layer removing hole. Meanwhile, a material that has requisite resistance to various treatments in the production process is typically used for the substrate. Therefore, it is difficult to select a sacrifice layer material that satisfies the needs for resistance and processability described above from among materials different from the substrate material, more specifically, from among materials that have a relationship with the substrate material that the substrate material is not etched and only the sacrifice layer material is etched.

In the present embodiment, a sacrifice layer that satisfies the needs for resistance (e.g., heat resistance) to various treatments in the production process of the oscillator substrate and etching processability is obtained by forming the sacrifice layer using the same material as the substrate.

However, in this case, there is a risk that the substrate may be etched when removing the sacrifice layer by etching through the sacrifice layer removing hole formed in the substrate. Hence, in the present embodiment, an etching protective film is formed over the internal wall surface of the sacrifice layer removing hole, and the sacrifice layer is later removed by etching through the sacrifice layer removing hole. This can suppress the substrate from being etched when removing the sacrifice layer by etching.

### [Second embodiment]

The second embodiment is characterized as the first embodiment that further includes an electromechanical transducer forming step of forming an electromechanical transducer (e.g., a piezoelectric element) over the oscillating membrane.

The present embodiment can obtain a sacrifice layer that satisfies the needs for resistance to various treatments in the production process of an oscillator substrate having an electromechanical transducer as the oscillator and etching processability.

### [Third embodiment]

The third embodiment is characterized as the second embodiment in which the electromechanical transducer forming step includes a step of forming a first electrode 22 over the oscillating membrane, a step of forming a piezoelectric film 23 over the first electrode, and a step of forming a second electrode 24 over the piezoelectric element.

The present embodiment can form an electromechanical transducer through layer lamination steps.

### [Fourth embodiment]

The fourth embodiment is characterized as any one of the first to third embodiments that further includes a second protective film forming step of forming over the substrate, a second etching protective film (e.g., an oxide film 11) configured to protect the substrate from the etching, as an underlayer of the sacrifice layer.

According this embodiment, when some parts of the oscillation space face the substrate, the second etching protective film can suppress the substrate portions facing these parts of the oscillation space from being etched when removing the sacrifice layer by etching.

### [Fifth embodiment]

The fifth embodiment is characterized as any one of the first to fourth embodiments that further includes a third protective film forming step of forming over the sacrifice layer, a third etching protective film (e.g., a silicon oxide film 19) configured to protect the oscillating membrane from the etching, as an underlayer of the oscillating membrane.

According to this embodiment, the third etching protective film can suppress the oscillating membrane facing the oscillation space from being etched when removing the sacrifice layer by etching.

### [Sixth embodiment]

The sixth embodiment is characterized as any one of the first to fifth embodiments wherein the sacrifice layer forming step also forms the sacrifice layer within a region over the substrate facing a non-oscillating section of the oscillating membrane not acting as the oscillating section, and keeps the sacrifice layer (e.g., a remaining layer 14b) that is formed within that region remaining over the oscillator substrate.

This can ensure flatness of the upper surface of the oscillating membrane, and can improve the substrate stiffness.

### [Seventh embodiment]

The seventh embodiment is characterized as any one of the first to sixth embodiments wherein the substrate is a silicon (Si) substrate and the hole forming step forms the sacrifice layer removing hole by dry etching, and the protective film forming step forms the etching protective film over the internal wall surface of the sacrifice layer removing hole while performing dry etching in the hole forming step or in succession to the dry etching.

This can reduce the time taken by the production process, and can form the sacrifice layer removing hole while overcoming the problems of wet etching.

### [Eighth embodiment]

The eighth embodiment is characterized as the seventh embodiment wherein the protective film forming step forms a film mainly containing carbon and fluorine as the etching protective film.

This can effectively protect the internal wall surface of the sacrifice layer removing hole formed in the substrate from etching.

### [Ninth embodiment]

The ninth embodiment is characterized as any one of the first to eighth embodiments wherein the steps from the hole forming step to the sacrifice layer removing step are performed in the same device.

Use of the same material for the substrate and the sacrifice layer makes it possible to perform processing (e.g., etching) to the sacrifice layer using the same device as used for processing (e.g., etching) the substrate, and improve productivity.

## Claims

1. A method for producing an oscillator substrate in which an oscillating section (17a) of an oscillating membrane (17) facing an oscillation space (15) is configured to oscillate in a direction normal to a membrane surface of the oscillating membrane (17), the method comprising the subsequential steps:
forming a sacrifice layer (14) within a region over a substrate (10) intended to become the oscillation space (15), the sacrifice layer (14) being formed of a same material as the substrate (10);
forming the oscillating membrane (17) on the sacrifice layer (14);
forming sacrifice layer removing holes (12) in the substrate in a manner to lead to the sacrifice layer (14) from a surface of the substrate (10) opposite to the sacrifice layer (14);
forming an etching protective film (13) over an internal wall surface of the sacrifice layer removing holes (12); and
removing the sacrifice layer (14) by etching through the sacrifice layer removing holes (12) to form the oscillation space (15).

2. The method for producing an oscillator substrate according to claim 1, comprising forming an electromechanical transducer over the oscillating membrane (17).

3. The method for producing an oscillator substrate according to claim 2,
wherein the forming the electromechanical transducer comprises:
forming a first electrode (22) over the oscillating membrane (17);
forming a piezoelectric film (23) over the first electrode (22); and
forming a second electrode (24) over the piezoelectric film (23).

4. The method for producing an oscillator substrate according to any one of claims 1 to 3, comprising
forming over the substrate (10), a second etching protective film configured to protect the substrate (10) from the etching, as an underlayer of the sacrifice layer (14).

5. The method for producing an oscillator substrate according to any one of claims 1 to 4, comprising
forming over the sacrifice layer (14), a third etching protective film configured to protect the oscillating membrane (17) from the etching, as an underlayer of the oscillating membrane (17).

6. The method for producing an oscillator substrate according to any one of claims 1 to 5,
wherein the forming the sacrifice layer (14) comprises also forming the sacrifice layer (14) within a region over the substrate (10) facing a non-oscillating section of the oscillating membrane (17) not acting as the oscillating section, and keeping the sacrifice layer (14) formed within the region remaining over the oscillator substrate.

7. The method for producing an oscillator substrate according to any one of claims 1 to 6,
wherein the substrate (10) is a silicon (Si) substrate,
wherein the forming the sacrifice layer removing holes (12) comprises forming the sacrifice layer removing holes (12) by dry etching, and
wherein the forming the etching protective film (13) comprises forming the etching protective film (13) over the internal wall surface of the sacrifice layer removing holes (12) while performing the dry etching in the forming the sacrifice layer removing holes (12) or in succession to the dry etching.

8. The method for producing an oscillator substrate according to claim 7,
wherein the forming the etching protective film (13) comprises forming a film that mainly comprises carbon and fluorine as the etching protective film (13).

9. The method for producing an oscillator substrate according to any one of claims 1 to 8,
wherein steps from the forming the sacrifice layer removing holes (12) to the removing the sacrifice layer (14) are performed in a same device.

## Patentansprüche

1. Verfahren zum Herstellen eines Oszillatorsubstrats, bei dem ein oszillierender Abschnitt (17a) einer oszillierenden Membran (17), der einem Oszillationsraum (15) gegenüberliegt, konfiguriert ist, in einer Richtung senkrecht zu einer Membranoberfläche der oszillierenden Membran (17) zu oszillieren, wobei das Verfahren die nachfolgenden Schritte umfasst:
Bilden einer Opferschicht (14) innerhalb einer Region über einem Substrat (10), die der Oszillationsraum (15) werden soll, wobei die Opferschicht (14) aus einem gleichen Material wie das Substrat (10) gebildet ist;
Bilden der oszillierenden Membran (17) auf der Opferschicht (14);
Bilden von Opferschicht-Entfernungslöchern (12) in dem Substrat in einer Weise, um zu der Opferschicht (14) von einer der Opferschicht (14) gegenüberliegenden Oberfläche des Substrats (10) zu führen;
Bilden eines Ätzschutzfilms (13) über einer Innenwandoberfläche der Opferschicht-Entfernungslöcher (12); und
Entfernen der Opferschicht (14) durch Ätzen durch die Opferschicht-Entfernungslöcher (12), um den Oszillationsraum (15) zu bilden.

2. Verfahren zum Herstellen eines Oszillatorsubstrats nach Anspruch 1, umfassend, das Bilden eines elektromechanischen Wandlers über die oszillierende Membran (17).

3. Verfahren zum Herstellen eines Oszillatorsubstrats nach Anspruch 2,
wobei das Bilden des elektromechanischen Wandlers umfasst:
Bilden einer ersten Elektrode (22) über der oszillierenden Membran (17);
Bilden eines piezoelektrischen Films (23) über der ersten Elektrode (22); und
Bilden einer zweiten Elektrode (24) über dem piezoelektrischen Film (23).

4. Verfahren zum Herstellen eines Oszillatorsubstrats nach einem der Ansprüche 1 bis 3, umfassend
Bilden, über dem Substrat (10), eines zweiten Ätzschutzfilms, konfiguriert zum Schützen des Substrats (10) vor dem Ätzen, als eine Unterschicht der Opferschicht (14).

5. Verfahren zum Herstellen eines Oszillatorsubstrats nach einem der Ansprüche 1 bis 4, umfassend
Bilden, über der Opferschicht (14), eines dritten Ätzschutzfilms, konfiguriert zum Schützen der oszillierenden Membran (17) vor dem Ätzen, als eine Unterschicht der oszillierenden Membran (17).

6. Verfahren zum Herstellen eines Oszillatorsubstrats nach einem der Ansprüche 1 bis 5,
wobei das Bilden der Opferschicht (14) außerdem das Bilden der Opferschicht (14) in einer Region über dem Substrat (10), die einem nicht oszillierenden Abschnitt der oszillierenden Membran (17) gegenüberliegt, die nicht als der oszillierende Abschnitt wirkt, und das Verbleiben der Opferschicht (14), die in der Region gebildet wurde, über dem Oszillatorsubstrat, umfasst.

7. Verfahren zum Herstellen eines Oszillatorsubstrats nach einem der Ansprüche 1 bis 6,
wobei das Substrat (10) ein Silicium- (Si)-Substrat ist,
wobei das Bilden der Opferschicht-Entfernungslöcher (12) das Bilden der Opferschicht-Entfernungslöcher (12) durch Trockenätzen umfasst, und
wobei das Bilden des Ätzschutzfilms (13) das Bilden des Ätzschutzfilms (13) über der Innenwandoberfläche der Opferschicht-Entfernungslöcher (12) umfasst, während das Trockenätzen beim Bilden der Opferschicht-Entfernungslöcher (12) durchgeführt wird, oder im Anschluss an das Trockenätzen.

8. Verfahren zum Herstellen eines Oszillatorsubstrats nach Anspruch 7,
wobei das Bilden des Ätzschutzfilms (13) das Bilden eines Films, der hauptsächlich Kohlenstoff und Fluor umfasst, als den Ätzschutzfilm (13) umfasst.

9. Verfahren zum Herstellen eines Oszillatorsubstrats nach einem der Ansprüche 1 bis 8,
wobei die Schritte von dem Bilden der Opferschicht-Entfernungslöcher (12) bis zu dem Entfernen der Opferschicht (14) in einer selben Vorrichtung durchgeführt werden.

## Revendications

1. Procédé pour fabriquer un substrat d'oscillateur dans lequel une section oscillante (17a) d'une membrane oscillante (17) qui fait face à un espace d'oscillation (15) est configurée pour osciller dans une direction qui est perpendiculaire à une surface de membrane de la membrane oscillante (17), le procédé comprenant les étapes subséquentes qui suivent :
la formation d'une couche sacrificielle (14) à l'intérieur d'une région au-dessus d'un substrat (10) qui est destinée à devenir l'espace d'oscillation (15), la couche sacrificielle (14) étant formée en un même matériau que le substrat (10) ;
la formation de la membrane oscillante (17) sur la couche sacrificielle (14) ;
la formation de trous de suppression de couche sacrificielle (12) dans le substrat de manière à ce qu'ils cheminent jusqu'à la couche sacrificielle (14) depuis une surface du substrat (10) qui est opposée à la couche sacrificielle (14) ;
la formation d'un film de protection vis-à-vis de la gravure (13) au-dessus d'une surface de paroi interne des trous de suppression de couche sacrificielle (12) ; et
la suppression de la couche sacrificielle (14) par gravure au travers des trous de suppression de couche sacrificielle (12) afin de former l'espace d'oscillation (15).

2. Procédé pour fabriquer un substrat d'oscillateur selon la revendication 1, comprenant la formation d'un transducteur électromécanique au-dessus de la membrane oscillante (17).

3. Procédé pour fabriquer un substrat d'oscillateur selon la revendication 2, dans lequel la formation du transducteur électromécanique comprend :
la formation d'une première électrode (22) au-dessus de la membrane oscillante (17);
la formation d'un film piézoélectrique (23) au-dessus de la première électrode (22) ; et
la formation d'une seconde électrode (24) au-dessus du film piézoélectrique (23).

4. Procédé pour fabriquer un substrat d'oscillateur selon l'une quelconque des revendications 1 à 3, comprenant :
la formation, au-dessus du substrat (10), d'un deuxième film de protection vis-à-vis de la gravure qui est configuré pour protéger le substrat (10) vis-à-vis de la gravure, en tant que couche sous-jacente de la couche sacrificielle (14).

5. Procédé pour fabriquer un substrat d'oscillateur selon l'une quelconque des revendications 1 à 4, comprenant :
la formation, au-dessus de la couche sacrificielle (14), d'un troisième film de protection vis-à-vis de la gravure qui est configuré pour protéger la membrane oscillante (17) vis-à-vis de la gravure, en tant que couche sous-jacente de la membrane oscillante (17).

6. Procédé pour fabriquer un substrat d'oscillateur selon l'une quelconque des revendications 1 à 5,
dans lequel la formation de la couche sacrificielle (14) comprend également la formation de la couche sacrificielle (14) à l'intérieur d'une région au-dessus du substrat (10) qui fait face à une section non oscillante de la membrane oscillante (17) ne jouant pas le rôle de section oscillante, et le maintien de la couche sacrificielle (14) formée à l'intérieur de la région subsistant au-dessus du substrat d'oscillateur.

7. Procédé pour fabriquer un substrat d'oscillateur selon l'une quelconque des revendications 1 à 6,
dans lequel le substrat (10) est un substrat en silicium (Si) ;
dans lequel la formation des trous de suppression de couche sacrificielle (12) comprend la formation des trous de suppression de couche sacrificielle (12) par gravure par voie sèche ; et
dans lequel la formation du film de protection vis-à-vis de la gravure (13) comprend la formation du film de protection vis-à-vis de la gravure (13) au-dessus de la surface de paroi interne des trous de suppression de couche sacrificielle (12) pendant la réalisation de la gravure par voie sèche lors de la formation des trous de suppression de couche sacrificielle (12) ou à la suite de la gravure par voie sèche.

8. Procédé pour fabriquer un substrat d'oscillateur selon la revendication 7, dans lequel la formation du film de protection vis-à-vis de la gravure (13) comprend la formation d'un film qui comprend essentiellement du carbone et du fluor en tant que film de protection vis-à-vis de la gravure (13).

9. Procédé pour fabriquer un substrat d'oscillateur selon l'une quelconque des revendications 1 à 8, dans lequel les étapes qui vont de la formation des trous de suppression de couche sacrificielle (12) jusqu'à la suppression de la couche sacrificielle (14) sont réalisées dans un même dispositif.
